# FASCICULE DE BREVET EUROPEEN

(11) **EP 3 242 322 B1**
(45) Date de publication et mention de la délivrance du brevet: **15.01.2020**
(21) Numéro de dépôt: 17169055.5
(22) Date de dépôt: 02.05.2017
(51) Int. Cl.: H01L 23/36, H01L 23/367, H01L 23/495, H01L 23/498, H02M 7/537

(54) **DISPOSITIF ELECTRONIQUE DE PUISSANCE A STRUCTURE D'INTERCONNEXION ELECTRIQUE PLANE**
ELEKTRONISCHE LEISTUNGSVORRICHTUNG MIT FLACHER ELEKTRISCHER VERBINDUNGSSTRUKTUR
ELECTRONIC POWER DEVICE WITH PLANAR ELECTRICAL INTERCONNECTION STRUCTURE

(30) Priorité: 04.05.2016 FR 1654036
(43) Date de publication de la demande: 08.11.2017
(73) Titulaire: Commissariat à l'énergie atomique et aux énergies alternatives, 75015 Paris (FR); Centre National de la Recherche Scientifique, 75794 Paris Cedex 16 (FR)
(72) Inventeur: LETOWSKI, Bastien, 38000 GRENOBLE (FR); CREBIER, Jean-Christophe, 38690 BEVENAIS (FR); ROUGER, Nicolas, 83150 BANDOL (FR); WIDIEZ, Julie, 38000 GRENOBLE (FR)
(74) Mandataire: Brevalex

(56) Documents cités:
- EP-A1- 2 741 324
- JP-A- 2016 066 700
- US-A1- 2013 341 776
- US-A1- 2015 173 248
- B WEISS ET AL: "Monolithically-Integrated Multilevel Inverter on Lateral GaN-on-Si Technology for High-Voltage Applications", 2015 IEEE COMPOUND SEMICONDUCTOR INTEGRATED CIRCUIT SYMPOSIUM (CSICS), 1 janvier 2015 (2015-01-01), - 1 janvier 2015 (2015-01-01), pages 1-4, XP002765943,

## Description

### DOMAINE TECHNIQUE ET ART ANTÉRIEUR

L'invention concerne le domaine de l'électronique de puissance, et plus particulièrement un dispositif électronique de puissance comportant des composants électroniques de puissance latéraux, ainsi qu'un procédé de réalisation d'un tel dispositif électronique de puissance.

Le domaine de l'électronique de puissance suit le même chemin que celui de la microélectronique, avec un besoin croissant de réduction de l'encombrement et d'amélioration des performances des dispositifs. Partant de ce principe, des applications avec de plus en plus de fonctions intégrées sont développées, particulièrement pour les systèmes embarqués, du véhicule électrique à l'avion plus électrique, devant répondre à des critères stricts de fiabilité et de reproductibilité et également avoir un rapport coût/performance qui soit le meilleur possible.

Dans ce contexte, les composants électroniques de puissance réalisés à base de nitrure de gallium (GaN) épitaxié sur un substrat de silicium (Si) sont intéressants car le GaN apporte une bonne tenue en tension et une bonne stabilité en température à ces composants. De plus, de tels composants sont compatibles avec les procédés de fabrication sur silicium de type CMOS.

Le document EP2741324 divulgue un transistor III en nitrure avec une électrode source connectée à une plaque de répartition de chaleur.

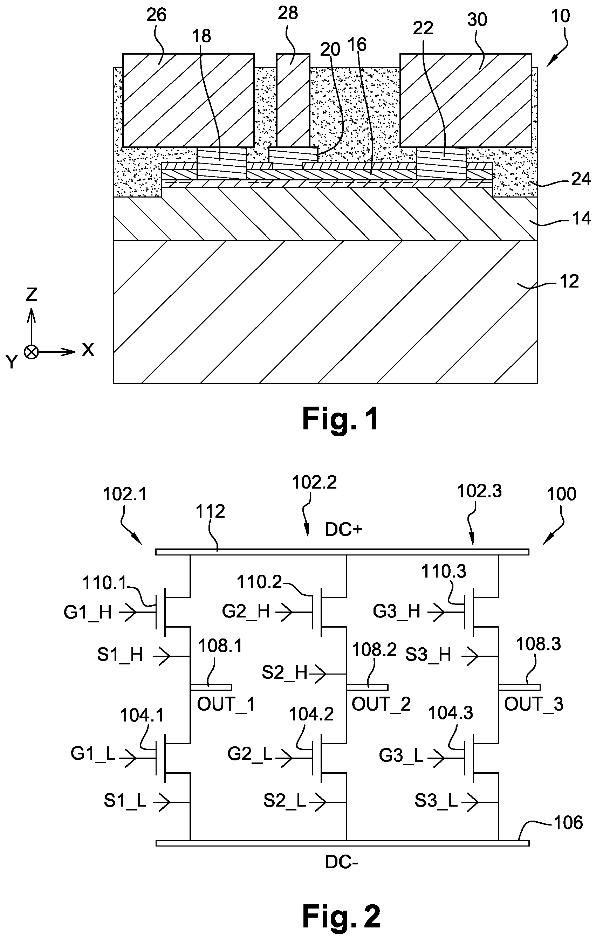

Un exemple de réalisation d'un tel composant électronique de puissance latéral est représenté sur la figure 1. Sur cette figure, le composant correspond à un transistor 10 de puissance de type HEMT (« High Electron Mobility Transistor » en anglais, ou transistor de puissance à haute mobilité électronique) à base de GaN. Ce transistor 10 est formé à partir d'un substrat de silicium 12 dont l'épaisseur est par exemple comprise entre environ 725 µm et 1000 µm. La partie active du transistor 10 est formée à partir d'une couche 14 de GaN sur laquelle est disposée une couche active 16 d'AIGaN ou d'AIN dans laquelle sont réalisées les régions de canal, de source et de drain du transistor 10. Des électrodes 18, 20 et 22 forment respectivement les électrodes de source, de grille et de drain du transistor 10. Des contacts métalliques 26, 28 et 30 servant à former les liaisons électriques du transistor 10 avec d'autres éléments sont également formés sur ces électrodes 18, 20, 22. Ces électrodes 18, 20, 22 et ces contacts métalliques 26, 28, 30 sont isolées électriquement les unes des autres par un diélectrique 24 formé autour d'eux. La somme des épaisseurs des couches 14 et 16 et des électrodes 18, 20 et 22 est par exemple inférieure à environ 10 µm.

Ce type de composant électronique de puissance réalisé à partir d'un substrat de type GaN sur silicium a une structure dite « latérale », c'est-à-dire comporte ses électrodes localisées sur une même face qui correspond à la face avant du composant. C'est également le cas des composants électroniques en silicium réalisés sur un substrat SOI (« Silicon On Insulator » en anglais, ou silicium sur isolant) par exemple de type LDMOS (« Lateral Diffused MOS » en anglais, ou MOS à diffusion latérale). Dans un tel composant électronique de puissance latéral, le courant électrique circule sensiblement parallèlement au substrat à partir duquel ce composant est réalisé, c'est-à-dire dans le plan (X,Y) dans le cas du transistor 10 représenté sur la figure 1.

Bien que ces composants électroniques de puissance latéraux aient des caractéristiques très intéressantes pour les applications de puissance, ils nécessitent un packaging particulièrement optimisé au niveau CEM (Compatibilité ElectroMagnétique) et thermique pour limiter, entre autres, les inductances parasites de boucles car les fronts de commutation de ces transistors sont très élevés. De plus, dans un tel composant, la totalité des courants circule dans une zone qui est très fine (quelques µm, le plus souvent inférieure à environ 10 µm). La densité de puissance à évacuer depuis ces composants est donc importante et un packaging performant est nécessaire pour évacuer la chaleur sur des petites dimensions.

De plus, dans un composant électronique de puissance latéral de type GaN sur silicium tel que le transistor 10 précédemment décrit, le substrat 12 présent en face arrière du composant est problématique pour son refroidissement qui est réalisé depuis sa face arrière du composant car le substrat 12 est épais et la conductivité du silicium est faible (148 W.m⁻¹.K⁻¹) par rapport à d'autres matériaux semi-conducteurs utilisés en électronique de puissance, comme par exemple le carbure de silicium (environ 500 W.m⁻¹.K⁻¹).

Des problèmes analogues se posent également pour des composants électroniques de puissance à structure dite « semi-latérale », ou « semi-verticale », tels que des transistors DMOS (« Double-Diffused Metal-Oxide-Semiconductor » en anglais). Dans un tel composant, toutes les électrodes sont localisées sur une même face qui correspond à la face avant du composant. Une des électrodes (source ou drain) est également présente en profondeur dans le composant, conférant au composant une tenue en tension verticale. Dans un tel composant, le courant circule donc verticalement et horizontalement, c'est-à-dire sensiblement parallèlement et perpendiculairement au substrat à partir duquel ce composant est réalisé.

La majorité des composants électroniques de puissance en GaN sont dessinés et fabriqués de manière collective. Ils sont ensuite découpés (isolant ainsi les composants) et assemblés dans des puces, et destinés à être utilisés de manière autonome, ce qui malheureusement ne permet pas de bénéficier des performances réelles apportées par la technologie GaN.

L'approche monolithique, qui consiste non pas à assembler des composants découpés au préalable ou de technologies différentes, mais à réaliser les composants d'un dispositif électronique de puissance de manière collective à partir d'un même substrat, met en avant une réponse à un besoin, une application spécifique, où les performances sont supérieures aux approches puce à puce, au niveau performances électriques, thermomécaniques et robustesse.

Le document B. Weiss et al., « Monolithically-Integrated Multilevel Inverter on Lateral GaN-on-Si Technology for High-Voltage Applications », 2015 IEEE Compound Semiconductor Integrated Circuit Symposium (CSICS), 2015, pp. 1-4, décrit la réalisation d'un onduleur multiniveaux monolithique dans lequel les composants et les plots d'interconnexion sont dessinés dans le contexte d'un convertisseur de puissance. Dans ce dispositif, les composants destinés à être reliés électriquement les uns aux autres sont positionnés côte à côte sur le substrat afin qu'une piste conductrice présente sur le substrat assure ces connexions électriques. Les plots de connexions de ces composants sont reliés à des plots de connexions externes par des fils conducteurs (« wire bonding » en anglais).

Le packaging proposé dans ce document, qui utilise une structure planaire et des fils conducteurs, limite toutefois fortement les performances électriques et thermiques pouvant être obtenues.

Le document WO 2015/157845 A1 décrit un packaging de composant électronique de puissance en GaN dans lequel les électrodes sont ramenées sur une face arrière du packaging, qui se trouve du côté de la face arrière du composant, grâce à des micro-vias de cuivre percés par laser. Un pad thermique favorisant la dissipation thermique est disposé du côté de la face avant du packaging, qui se trouve du côté de la face avant du composant. Ainsi, un bon refroidissement est obtenu du fait que le pad thermique se trouve du côté de la face avant du composant.

Toutefois, ce packaging n'est adapté qu'à des composants électroniques de puissance individuels et non à des dispositifs électroniques formés de plusieurs composants électroniques.

### EXPOSÉ DE L'INVENTION

Un but de la présente invention est de proposer un nouveau type de dispositif électronique de puissance à composants électroniques de puissance latéraux dans lequel la dissipation thermique de la chaleur générée par les composants électroniques de puissance latéraux est améliorée, tout en assurant une interconnexion électrique performante entre ces composants et une minimisation des perturbations électromagnétiques au sein du dispositif.

Pour cela, l'invention propose un dispositif électronique de puissance comportant au moins :
- une couche active comprenant au moins un semi-conducteur et dans laquelle plusieurs composants électroniques de puissance latéraux et/ou semi-latéraux sont réalisés, toutes les électrodes des composants étant disposées sur une face avant de la couche active ;
- une structure d'interconnexion électrique comprenant plusieurs portions électriquement conductrices solidarisées à la face avant de la couche active, auxquelles les électrodes des composants sont reliées électriquement, et dont au moins des premières parties disposées contre les électrodes des composants s'étendent dans un plan sensiblement parallèle à la couche active ;
- un support comprenant une face avant sur laquelle des pistes électriquement conductrices sont disposées,
et dans lequel la couche active et la structure d'interconnexion électrique sont solidarisées à la face avant du support telles que :
- la structure d'interconnexion électrique soit disposée entre la couche active et le support, les premières parties des portions électriquement conductrices étant disposées contre les pistes électriquement conductrices, ou
- la couche active soit disposée entre la structure d'interconnexion électrique et le support, les portions électriquement conductrices comportant en outre des deuxièmes parties s'étendant à côté de la couche active et reliant électriquement les premières parties des portions électriquement conductrices aux pistes électriquement conductrices.

Un tel dispositif électronique de puissance comporte une structure d'interconnexion électrique dont au moins une partie qui est disposée contre la face avant de la couche active forme une structure plane. Grâce à cette structure plane, il est possible de disposer les composants électroniques de puissance sur le support tels que la structure d'interconnexion électrique soit disposée entre la couche active et le support et contre les pistes électriquement conductrices se trouvant sur le support. Dans cette configuration, le support forme alors un élément de transfert thermique permettant d'évacuer efficacement la chaleur générée par les composants électroniques de puissance au niveau de la face avant de la couche active.

Une telle dissipation thermique de la chaleur générée par les composants électroniques n'est pas réalisable lorsque des fils de connexion sont utilisés pour relier électriquement les composants électroniques aux métallisations du support sur lequel reposent les composants électroniques de puissance.

Dans une autre configuration, la couche active est disposée entre la structure d'interconnexion électrique et le support. Dans ce cas, les premières parties des portions électriquement conductrices de la structure d'interconnexion électrique forment une structure plane apte à recevoir un dissipateur thermique permettant l'obtention d'une bonne dissipation thermique de la chaleur générée depuis la face avant des composants électroniques de puissance. Cette configuration a également pour avantage de permettre une séparation des chemins de propagation électrique et thermique dans le dispositif, c'est-à-dire un découplage optimal entre les grandeurs électromagnétiques et thermiques au sein du dispositif.

Ainsi, dans ces deux configurations, la structure plane formée par les portions électriquement conductrices de la structure d'interconnexion électrique permet l'association d'une bonne conduction électrique et d'une bonne conduction thermique, résolvant la problématique rencontrée dans les dispositifs de puissance de l'art antérieur.

En outre, la structure du dispositif électronique de puissance est telle que le dispositif peut comporter plusieurs composants électroniques de puissance, la dissipation thermique obtenue grâce à la structure planaire de la structure d'interconnexion électrique s'appliquant à ces différents composants électroniques de puissance.

Enfin, une telle structure d'interconnexion permet de réduire les perturbations électromagnétiques engendrées au sein du dispositif, notamment les inductances parasites de boucles ou de mailles de commutation, par rapport aux technologies standards faisant appel à des connexions de type ruban ou par fils.

Un tel dispositif électronique de puissance a également pour avantage de pouvoir être conçu et réalisé en utilisant des procédés collectifs permettant la réalisation simultanée de plusieurs dispositifs de manière fiable.

Le plan sensiblement parallèle à la couche active correspond à un plan sensiblement parallèle aux faces principales de la couche active qui sont les faces de plus grandes dimensions (par exemple de plus grand diamètre) de la couche active. Ainsi, dans le transistor 10 précédemment décrit en lien avec la figure 1, ce plan sensiblement parallèle à la couche active 16 est parallèle au plan (X,Y).

Lorsque les portions électriquement conductrices comportent des deuxièmes parties s'étendant à côté de la couche active, ces deuxièmes parties ne sont pas disposées au-dessus de la couche active mais s'étendent latéralement à côté de celle-ci.

L'expression « couche active » peut désigner une seule couche continue de matériau sur laquelle plusieurs composants électroniques de puissance sont réalisés collectivement. Cette expression désigne également plusieurs portions de matériau semi-conducteur dans lesquelles un ou plusieurs composants électroniques de puissance sont réalisés et qui, lorsqu'elles sont solidarisées à la structure d'interconnexion électrique au niveau de leur face avant, sont disposées les unes à côté des autres et forment ensemble cette couche active. Ainsi, les composants électroniques de puissance du dispositif électronique de puissance peuvent être réalisés collectivement ou non, c'est-à-dire à partir d'un même substrat ou de différents substrats.

Les composants électroniques de puissance latéraux et/ou semi-latéraux comportent avantageusement des électrodes planes, notamment totalement planes, qui peuvent s'étendre dans un plan sensiblement parallèle à la couche active. Ainsi, la structure plane formée par la structure d'interconnexion électrique peut être en contact direct avec ces électrodes planes. Il n'est donc pas nécessaire de contrôler les distances entre les électrodes et la structure d'interconnexion électrique.

De manière avantageuse, les composants électroniques de puissance latéraux et/ou semi-latéraux sont réalisés selon une approche monolithique, c'est-à-dire réalisés de manière collective à partir d'un même substrat.

De manière avantageuse, notamment lorsque la structure d'interconnexion est disposée entre la couche active et le support, le support peut comporter au moins un matériau de conductivité thermique supérieure à environ 148 W.m⁻¹.K⁻¹.

Une épaisseur des portions électriquement conductrices peut être comprise entre environ 50 µm et 1000 µm. Ainsi, les portions électriquement conductrices peuvent assurer également un maintien mécanique des composants électroniques de puissance. Par exemple, lorsque ces composants sont réalisés à partir d'un substrat comportant une couche support d'épaisseur typiquement supérieure à 200 µm (comme par exemple le substrat 12 pour le transistor 10 précédemment décrit en lien avec la figure 1) assurant le maintien mécanique des composants, une telle structure d'interconnexion électrique peut être solidarisée aux composants électroniques de puissance, avantageusement à l'échelle du wafer (c'est-à-dire pour des composants destinés à faire partie de plusieurs dispositifs électroniques de puissance, avec dans ce cas la structure d'interconnexion électrique qui correspond par exemple à une partie d'une couche métallique structurée), puis la couche support épaisse du substrat peut être supprimée préalablement à l'assemblage des composants électroniques de puissance sur le support du dispositif.

De plus, une telle épaisseur des portions électriquement conductrices est favorable à l'obtention à la fois d'une très bonne conduction électrique et d'une très bonne conduction thermique.

Au moins les premières parties des portions électriquement conductrices peuvent former des parallélépipèdes rectangles. Ces parallélépipèdes rectangles peuvent être avantageusement orientés sensiblement parallèlement les uns aux autres. Une disposition différente des portions électriquement conductrices de la structure d'interconnexion est toutefois possible.

Le dispositif électronique de puissance peut comporter en outre, lorsque la couche active est disposée entre la structure d'interconnexion électrique et le support, au moins un dissipateur thermique disposé sur la structure d'interconnexion électrique tel que la structure d'interconnexion électrique soit disposée entre le dissipateur thermique et la couche active. Ainsi, l'évacuation de la chaleur générée depuis la face avant des composants électroniques de puissance latéraux est favorablement réalisée à travers la structure d'interconnexion électrique et ce dissipateur thermique. Lorsque le dissipateur thermique comporte un matériau électriquement conducteur, une couche diélectrique peut être interposée entre le dissipateur thermique et la structure d'interconnexion électrique. Pour éviter un court-circuit des différents éléments de la structure d'interconnexion électrique, un diélectrique peut être présent entre le dissipateur thermique et la structure d'interconnexion électrique.

Le dispositif électronique de puissance peut comporter en outre au moins un condensateur de découplage tel que :
- lorsque la structure d'interconnexion électrique est disposée entre la couche active et le support, ledit au moins un condensateur de découplage soit disposé sur une partie des pistes électriquement conductrices et relié électriquement aux pistes électriquement conductrices, ou
- lorsque la couche active est disposée entre la structure d'interconnexion électrique et le support, ledit au moins un condensateur de découplage soit disposé sur les deuxièmes parties des portions électriquement conductrices et relié électriquement aux deuxièmes parties des portions électriquement conductrices, ou disposé sur les premières parties des portions électriquement conductrices.

Ainsi, le ou les condensateurs de découplage sont disposés au plus près des composants électroniques de puissance. Cette disposition du ou des condensateurs de découplage permet donc de réaliser un découplage capacitif au plus près des composants électroniques de puissance, minimisant les interconnexions entre ces composants et ce ou ces condensateurs. Ce ou ces condensateurs de découplage permettent également de filtrer les perturbations de mode différentiel, générées par les commutations au sein du dispositif, au plus près de la source de ces perturbations, réduisant ainsi la maille de circulation du courant entre le ou les condensateurs et les composants électroniques de puissance.

Toutefois, il est également possible que le ou les condensateurs de découplage soient disposés sur le support à côté des pistes électriquement conductrices, avec dans ce cas des éléments de connexion électrique supplémentaires reliant électriquement ce ou ces condensateurs de découplage à la structure d'interconnexion électrique.

Lorsque la couche active est disposée entre la structure d'interconnexion électrique et le support et que ledit au moins un condensateur de découplage est disposé sur les premières parties des portions électriquement conductrices, le dissipateur thermique peut être disposé sur ledit au moins un condensateurs de découplage. Dans cette configuration, le ou les condensateurs de découplage forme une couche supplémentaire augmentant la résistance thermique entre la zone active des composants électroniques de puissance et l'air ambiant.

Le dispositif électronique de puissance peut comporter en outre, lorsque la couche active est disposée entre la structure d'interconnexion électrique et le support, au moins une première couche métallique disposée entre le support et la couche active et sur laquelle un premier potentiel d'alimentation électrique du dispositif électronique de puissance est destiné à être appliqué et/ou, lorsque le dispositif électronique de puissance comporte au moins un dissipateur thermique disposé sur la structure d'interconnexion électrique, au moins une deuxième couche métallique disposée entre le dissipateur thermique et la structure d'interconnexion électrique et sur laquelle un deuxième potentiel d'alimentation électrique du dispositif électronique de puissance est destiné à être appliqué.

Ces première et deuxième couches métalliques forment ainsi des écrans électrostatiques interposés entre la structure d'interconnexion électrique et le support et entre la structure d'interconnexion électrique et le dissipateur thermique. Ces écrans électrostatiques éloignent la structure d'interconnexion électrique vis-à-vis du support et du dissipateur thermique, et réduisent les capacités parasites de mode de commun car les potentiels électriques perturbateurs (correspondant aux signaux de sortie du dispositif électronique de puissance) sont confinés par les potentiels électriques d'alimentation appliqués sur ces couches métalliques. Des couches diélectriques peuvent être présentes sur et/ou sous ces couches métalliques pour éviter des court-circuits qui pourraient se créer au sein du dispositif électronique à cause de ces couches métalliques.

Le dispositif électronique de puissance peut être tel que :
- la couche active comporte au moins du GaN et/ou de l'AIGaN et/ou de l'AIN, et/ou les composants comportent des transistors de type HEMT, ou
- la couche active comporte au moins du silicium, et/ou les composants comportent des transistors de type MOS et/ou JFET (« Junction Field Effect Transistor » en anglais) et/ou IGBT (« Insulated Gâte Bipolar Transistor » en anglais) et/ou BJT (« Bipolar junction transistor » en anglais) et/ou DMOS.

Au moins une partie des composants électroniques de puissance peuvent former au moins une cellule de commutation, et/ou le dispositif électronique de puissance peut comporter au moins un convertisseur statique comprenant plusieurs cellules de commutation reliées électriquement entre elles.

Ainsi, le dispositif électronique de puissance peut comporter un convertisseur statique tel qu'un onduleur, un hacheur, un redresseur ou encore un gradateur, et/ou un convertisseur polyphasé tel qu'un hacheur entrelacé et/ou une association de cellules de commutation et de transistors de puissance en série, comme dans le cas d'un onduleur multiniveaux.

Les composants électroniques de puissance peuvent être disposés sur au moins un substrat semi-conducteur tel que :
- lorsque la structure d'interconnexion électrique est disposée entre la couche active et le support, la couche active est disposée entre le substrat semi-conducteur et la structure d'interconnexion électrique, ou
- lorsque la couche active est disposée entre la structure d'interconnexion électrique et le support, le substrat semi-conducteur est disposé entre la couche active et le support.

Toutefois, de manière avantageuse, un tel substrat semi-conducteur pouvant être présent lors de la réalisation des composants électroniques de puissance peut être supprimé lors de la réalisation du dispositif électronique de puissance. Ainsi, lorsque la structure d'interconnexion électrique est disposée entre la couche active et le support, la face arrière de la couche active n'est alors plus recouverte par un tel substrat semi-conducteur. Lorsque la couche active est disposée entre la structure d'interconnexion électrique et le support, un tel substrat semi-conducteur n'est plus présent entre la couche active et le support. En supprimant ce substrat, une meilleure optimisation de la tenue en tension et des performances des composants est obtenue.

L'invention porte également sur un procédé de réalisation d'un dispositif électronique de puissance, comportant au moins la mise en œuvre des étapes suivantes :
- réalisation de plusieurs composants électroniques de puissance latéraux et/ou semi-latéraux dans au moins une couche active comprenant au moins un semi-conducteur tels que toutes les électrodes des composants soient disposées sur une face avant de la couche active ;
- solidarisation de la face avant de la couche active à une structure d'interconnexion électrique comprenant plusieurs portions électriquement conductrices auxquelles les électrodes des composants sont reliées électriquement, et dont au moins des premières parties disposées contre les électrodes des composants s'étendent dans un plan sensiblement parallèle à la couche active ;
- solidarisation de la couche active et de la structure d'interconnexion électrique à une face avant d'un support sur laquelle s'étendent des pistes électriquement conductrices, telle que :
   - la structure d'interconnexion électrique soit disposée entre la couche active et le support, les premières parties des portions électriquement conductrices étant disposées contre les pistes électriquement conductrices, ou
   - la couche active soit disposée entre la structure d'interconnexion électrique et le support, les portions électriquement conductrices comportant des deuxièmes parties s'étendant à côté de la couche active et reliant électriquement les premières parties aux pistes électriquement conductrices.

Un tel procédé est notamment compatible avec une mise en œuvre collective, à l'échelle du substrat, réalisant simultanément plusieurs dispositifs électroniques de puissance.

De plus, ce procédé peut mettre en œuvre des techniques de collage et d'assemblage permettant de maximiser les caractéristiques thermiques et électriques de l'interface entre le semi-conducteur et les conducteurs.

Il est possible que les composants électroniques de puissance soient réalisés à partir de substrats différents. Dans ce cas, les composants sont découpés puis solidarisés, au niveau de leur face avant, à la structure d'interconnexion électrique. Les parties actives de ces composants qui sont alors disposées les unes à côté des autres forment ensemble la couche active.

De manière avantageuse, les composants électroniques sont réalisés collectivement à partir d'une seule couche active continue de semi-conducteur. Dans ce cas, lorsque la structure d'interconnexion électrique est disposée entre la couche active et le support :
- les composants électroniques de puissance peuvent être réalisés collectivement dans la couche active qui est disposée sur un substrat semi-conducteur,
- la solidarisation de la face avant de la couche active à la structure d'interconnexion électrique peut correspondre à une solidarisation de la face avant de la couche active à une couche métallique structurée destinée à former la structure d'interconnexion électrique.

Ainsi, les structures d'interconnexion électrique de plusieurs dispositifs électroniques de puissance dont les composants sont réalisés à partir d'un même substrat peuvent être réalisées collectivement à l'échelle du substrat.

Dans ce cas, le procédé peut comporter en outre, entre la solidarisation de la face avant de la couche active à la couche métallique structurée et la solidarisation de la couche active et de la structure d'interconnexion électrique à la face avant du support, une étape de suppression du substrat semi-conducteur. Dans ce cas, la couche métallique structurée est utilisée en tant que structure de maintien mécanique lors de la suppression du substrat semi-conducteur.

De plus, le procédé peut comporter en outre, entre la solidarisation de la face avant de la couche active à la couche métallique structurée et la solidarisation de la couche active et de la structure d'interconnexion électrique à la face avant du support, une étape de découpe d'au moins la couche active et la couche métallique structurée, formant un empilement qui est ensuite reporté sur la face avant du support. Cette découpe peut former des puces individuelles correspondant aux dispositifs électroniques de puissance qui sont ensuite reportés sur le support

En variante, lorsque la couche active est disposée entre la structure d'interconnexion électrique et le support :
- les composants peuvent être réalisés collectivement dans la couche active qui est disposée sur un substrat semi-conducteur,
- la couche active peut être solidarisée à la face avant du support avant la solidarisation de la structure d'interconnexion électrique à la face avant de la couche active,
et le procédé peut comporter en outre, entre la réalisation des composants et la solidarisation de la couche active à la face avant du support, une étape de découpe du substrat semi-conducteur et de la couche active, formant un empilement qui est ensuite reporté sur la face avant du support.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un exemple de réalisation d'un composant électronique de puissance latéral ;
- la figure 2 représente le schéma électrique d'un dispositif électronique de puissance, objet de la présente invention, correspondant à un convertisseur statique ;
- la figure 3 représente schématiquement un dispositif électronique de puissance, objet de la présente invention, selon un premier mode de réalisation ;
- la figure 4 représente schématiquement les électrodes des composants électroniques de puissance latéraux d'un dispositif électronique de puissance, objet de la présente invention, selon un exemple de réalisation ;
- la figure 5 représente schématiquement un module électronique faisant partie d'un dispositif électronique de puissance, objet de la présente invention, selon un exemple de réalisation ;
- les figures 6 et 7 représentent schématiquement un dispositif électronique de puissance, objet de la présente invention, selon un deuxième mode de réalisation ;
- la figure 8 représente une vue en coupe d'un dispositif électronique de puissance, objet de la présente invention, selon une première variante du deuxième mode de réalisation ;
- la figure 9 représente une vue en coupe d'un dispositif électronique de puissance, objet de la présente invention, selon une deuxième variante du deuxième mode de réalisation ;
- les figures 10 et 11 représentent schématiquement un dispositif électronique de puissance, objet de la présente invention, selon une variante du deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 2 représente le schéma électrique d'un exemple de réalisation d'un dispositif électronique de puissance 100 correspondant à un convertisseur statique. Ce convertisseur statique correspond par exemple à un onduleur ou un hacheur polyphasé, ici triphasé, comprenant trois cellules de commutation 102 (chaque cellule formant un bras du convertisseur statique), respectivement référencées 102.1, 102.2 et 102.3 sur la figure 2, et par exemple utilisé pour l'alimentation et la commande de machines tournantes alternatives, de moteurs triphasés, etc.

Chaque bras du convertisseur comporte au moins deux composants électroniques de puissance latéraux et/ou semi-latéraux, de structure par exemple similaire à celle du transistor 10 précédemment décrit en lien avec la figure 1.

Les composants électroniques de puissance latéraux du dispositif 100 sont par exemple réalisés en technologie silicium sur SOI et correspondent par exemple à des transistors de type MOS, notamment des transistors de type LDMOS, desJFET, des IGBT ou encore des BJT ou bien des transistors DMOS, ou sont réalisés avantageusement à base de GaN, comme par exemple des transistors de type HEMT, par exemple de structure similaire à celle du transistor 10 précédemment décrit. Pour des composants électroniques nécessitant des tenues en tension supérieure à environ 100 V voire supérieure à environ 200 V, il est également possible de réaliser les composants électroniques de puissance du dispositif 100 par des technologies dites semi-verticales, tels que des transistors DMOS. La structure de tels transistors est par exemple décrite dans le document K. Pinardi et al., « High-Power SOI Vertical DMOS Transistors With Lateral Drain Contacts: Process Developments, Characterization, and Modeling », IEEE Transactions on Electron Devices, vol.51, n°5, mai 2004.

De manière générale, les composants électroniques de puissance latéraux du dispositif 100 peuvent être des transistors et/ou des thyristors et/ou des diodes antiparallèles et/ou des diodes de redressement.

Sur l'exemple de la figure 2, chacune des cellules de commutation 102 comporte un premier transistor de puissance 104 (référencés 104.1, 104.2 et 104.3 pour chacune des cellules 102.1, 102.2 et 102.3) dont le drain est relié à un premier élément électriquement conducteur 106 qui est commun aux trois cellules de commutation 102 et sur lequel est appliqué un premier potentiel d'alimentation électrique DC- qui correspond par exemple à la masse. La source de chacun des premiers transistors 104 est reliée à un deuxième élément électriquement conducteur 108 (référencés 108.1, 108.2, 108.3 pour chacune des cellules 102.1, 102.2 et 102.3) sur lesquels les signaux de sortie appelés OUT_1, OUT_2 et OUT_3 de chacune des cellules de commutation 102 sont récupérés.

Chacune des cellules de commutation 102 comporte également un deuxième transistor de puissance 110 (référencés 110.1, 110.2 et 110.3 pour chacune des cellules 102.1, 102.2 et 102.3) dont le drain est relié à un troisième élément électriquement conducteur 112 commun aux trois cellules de commutation 102 et sur lequel est appliqué un deuxième potentiel d'alimentation électrique DC+ correspondant ici au potentiel électrique positif de l'alimentation. La source de chacun des deuxièmes transistors 110 est reliée à l'un des deuxièmes éléments 108.

Il est possible que la source et le drain de chacun des transistors 104 et 110 soient reliés l'un à l'autre par une diode antiparallèle de puissance (non représentée sur la figure 2). Ces diodes antiparallèles peuvent être intégrées aux transistors, ou correspondre à des composants distincts des transistors.

Les grilles des transistors 104 et 110 sont reliées à un circuit de commande, ou driver, non visible sur la figure 2, et apte à commander la commutation des cellules 102 du dispositif 100 via l'application de signaux G1_H ; G2_H, G3_H, G1_L, G2_L et G3_L sur ces grilles.

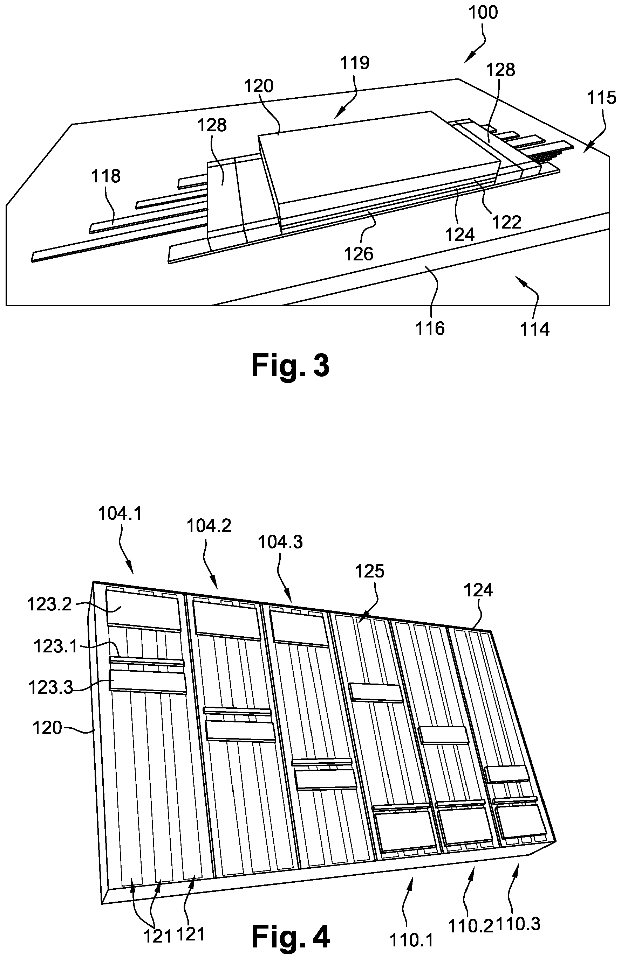

La figure 3 représente un premier mode de réalisation du dispositif 100.

Le dispositif 100 comporte un support 114 de type circuit imprimé (également appelé PCB ou « Printed Circuit Board » en anglais) ou correspondant à un substrat DBC (« Direct Bond Copper» en anglais, c'est-à-dire comportant une couche céramique métallisée). Le support 114 comporte une couche diélectrique 116 correspondant par exemple à une couche d'epoxy dans le cas d'un support 114 de type PCB ou une couche céramique dans le cas d'un support 114 de type DBC. Le support 114 comporte également des pistes électriquement conductrices 118, ou métallisations, par exemple en cuivre, disposées sur une face avant 115 de la couche 116.

Le dispositif 100 comporte également un module électronique de puissance 119 comprenant les composants électroniques de puissance latéraux formant les cellules de commutation 102 précédemment décrites, et formant donc les éléments de commutation du convertisseur statique.

Sur le premier mode de réalisation représenté sur la figure 3, les composants électroniques de puissance sont des composants latéraux de type GaN sur silicium et ont une structure similaire à celle du transistor 10 décrit précédemment en lien avec la figure 1. Les composants sont par exemple réalisés collectivement à partir d'un même substrat de type GaN sur silicium comprenant un substrat, ou couche support, de silicium 120 (similaire au substrat 12), une couche de GaN 122 (similaire à la couche 14) et une couche active 124 d'AIGaN ou d'AIN ou de GaN (similaire à la couche 16) dans laquelle les parties actives des composants (régions de canal, de source et de drain pour des transistors) sont réalisées. Des électrodes (non visibles sur la figure 3) sont réalisées sur la face avant de la couche active 124, et forment ici les électrodes de source, de grille et de drain des transistors 104, 110. Des contacts métalliques similaires aux contacts 26, 28 et 30 du transistor 10 sont réalisés sur les électrodes de chacun des transistors 104, 110.

Les composants électroniques de puissance peuvent être tels que :
- la couche active 124 comporte au moins du GaN et/ou de l'AIGaN et/ou d'AIN, et/ou les composants électroniques de puissance latéraux comportent des transistors de type HEMT, ou
- la couche active 124 comporte au moins du silicium, et/ou les composants électroniques de puissance latéraux comportent des transistors de type MOS et/ou JFET et/ou IGBT et/ou BJT et/ou DMOS.

Le ou les matériaux des couches 122, 124 et du substrat 120 sont choisis en fonction de la technologie de réalisation des composants électroniques de puissance latéraux du dispositif 100.

Le module 119 comporte également une structure d'interconnexion électrique 126, par exemple réalisée sous la forme d'un cadre métallique (ou « Lead Frame » métallique) et comportant par exemple du cuivre. La structure 126 comporte plusieurs portions électriquement conductrices disjointes reliant électriquement entre eux les composants électroniques de puissance formant les cellules de commutation 102. Ces portions conductrices forment des parallélépipèdes rectangles orientés sensiblement parallèlement les uns aux autres, et s'étendant parallèlement à la face avant 115 de la couche 116 du support 114. Ces portions électriquement conductrices s'étendent ici parallèlement aux pistes électriquement conductrices 118. Dans l'exemple de réalisation décrit ici, trois des portions électriquement conductrices de la structure 126 forment les points milieu des cellules de commutation 102 et les bornes de sortie de ces cellules de commutation 102, et correspondent aux deuxièmes éléments conducteurs 108.1, 108.2, 108.3 précédemment décrits en lien avec la figure 2. Six autres portions électriquement conductrices de la structure 126 sont reliées chacune à l'une des grilles des transistors 104 et 110. Enfin, deux autres portions électriquement conductrices de la structure 126 correspondent aux éléments conducteurs 106 et 112 précédemment décrits en lien avec la figure 2.

Les portions électriquement conductrices de la structure 126 sont en contact avec les électrodes (par l'intermédiaire des contacts métalliques surmontant les électrodes) des composants électroniques de puissance se trouvant en face avant de ces composants. Pour obtenir les connexions électriques du convertisseur statique précédemment décrit en liaison avec la figure 2, chaque portion électriquement conductrice de la structure 126 est en contact soit avec une seule électrode (pour les portions en contact avec les électrodes de grille) soit avec deux électrodes (pour les portions formant les deuxièmes éléments conducteurs 108) soit avec trois électrodes (pour les portions formant les éléments conducteurs 106 et 112).

La solidarisation qui relie électriquement les contacts métalliques de ces composants aux portions électriquement conductrices de la structure 126 est par exemple réalisée par un collage cuivre-cuivre lorsque les portions électriquement conductrices et les contacts métalliques comportent du cuivre.

En variante, il est possible que les transistors 104, 110 soient réalisés séparément les uns des autres, c'est-à-dire non collectivement, et que ces transistors soient solidarisés à la structure 126 individuellement.

Le module 119 est reporté sur la face avant 115 de la couche 116 tel que les portions électriquement conductrices de la structure 126 soient disposées contre les pistes électriquement conductrices 118 et reliées électriquement à ces pistes 118. Ce report peut être réalisé par une méthode de type flip-chip ou brasage.

Du fait que les faces avants des composants électroniques de puissance, ici les transistors 104 et 110, sont disposées contre le support 114 via la structure 126, et que de la chaleur est générée par ces composants au niveau de leur face avant, une bonne évacuation de la chaleur est obtenue à travers le support 114, via la structure d'interconnexion électrique 126, qui forme un bon élément de dissipation thermique.

Cette configuration est également avantageuse car elle permet la disposition d'autres composants électroniques, notamment des composants passifs, au plus près des composants de puissance formant le convertisseur. Ainsi, sur l'exemple de la figure 3, deux condensateurs de découplage 128 sont disposés sur le support 114, à proximité des faces latérales du module 119. Ces condensateurs 128 sont ici de type CMS (« Composant Monté en Surface », ou SMD en anglais pour « Surface Mounted Device ») et sont brasés directement sur les pistes conductrices 118. Dans l'exemple décrit ici, chaque condensateur 128 comporte deux électrodes chacune reliée électriquement à l'une des pistes 118 correspondant à l'un des deux éléments conducteurs 106, 112. En variante, ces condensateurs 128 peuvent être disposés sur le support 114 à côté des pistes 118, avec dans ce cas des éléments de liaison électrique supplémentaires pour les relier électriquement au module 119.

Avec une telle structure, les condensateurs 128 réalisent un filtrage des perturbations de mode différentiel générées par les commutations des composants, ici les transistors, des cellules de commutation 102, ce filtrage étant réalisé au plus près de ces composants et donc de la source de ces perturbations. La maille de circulation du courant entre les condensateurs 128 et les composants formant les cellules de commutation est dont réduite au maximum, ce qui réduit les perturbations de mode différentiel au sein du dispositif 100.

Le dispositif 100 comporte également un circuit de commande, ou driver, non visible sur la figure 3, apte à commander la commutation des cellules 102 et qui est reporté sur la face avant 115 de la couche 116 du support 114. Ce circuit peut comporter des composants électroniques basse tension, par exemple des transistors CMOS. Ce circuit de commande est relié aux grilles des transistors 104, 110 par l'intermédiaire des pistes 118.

Le dispositif 100 peut comporter également d'autres composants électroniques, par exemple des éléments passifs tels qu'une ou plusieurs inductances, disposés sur la face avant 115 de la couche 116 du support 114.

Dans l'exemple précédemment décrit, le dispositif 100 comporte des cellules de commutation 102 chacune formée de deux transistors de puissance, chacun pouvant être optionnellement couplé à une diode antiparallèle. Ces deux transistors peuvent être de types complémentaires (N et P) ou du même type.

Une cellule de commutation comporte au moins deux interrupteurs fonctionnant de manière complémentaire, chaque interrupteur pouvant être commandé (tel qu'un transistor ou un thyristor) ou non (diode de puissance). Les deux interrupteurs de la cellule de commutation peuvent chacun correspondre à un interrupteur commandé couplé à une diode antiparallèle.

La figure 4 représente schématiquement les contacts métalliques 123 des transistors 104 et 110 qui sont présents sur la face avant 125 de la couche active 124 et qui sont destinés à être solidarisées à la structure d'interconnexion électrique 126. Chacun des transistors 104.1-104.3 et 110.1-110.3 comporte trois contacts métalliques : un premier contact 123.1 relié à l'électrode de grille du transistor, un deuxième contact 123.2 relié à l'électrode de drain du transistor et un troisième contact 123.3 relié à l'électrode de source du transistor. Les électrodes 121 de chacun des transistors 104 et 110 sont ici réalisées sous la forme de doigts interdigités, ce qui permet une utilisation optimum de toute la surface de semi-conducteur de la couche active pour chacun des transistors 104, 110.

Les liaisons électriques entre ces contacts 123 des différents transistors 104, 110 sont réalisées en solidarisant les portions électriquement conductrices de la structure 126 contre ces contacts métalliques.

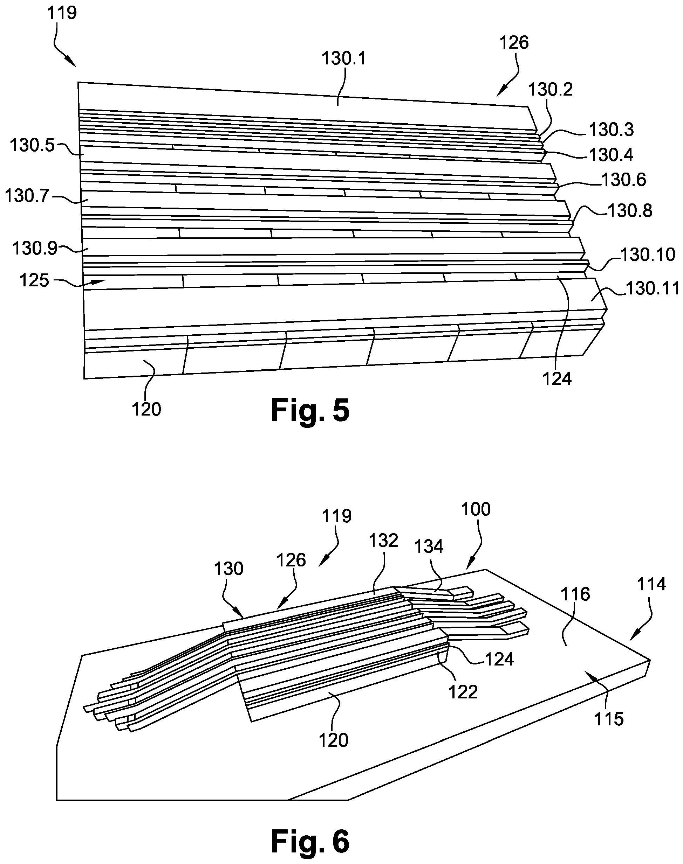

La figure 5 représente schématiquement le module 119 obtenu lorsque la structure d'interconnexion électrique 126 est solidarisée contre ces contacts métalliques 123. Sur cet exemple, la structure 126 comporte onze portions électriquement conductrices 130, référencées 130.1-130.11 sur la figure 5, formant des parallélépipèdes rectangles orientés sensiblement parallèlement les uns aux autres, et dont l'épaisseur (c'est-à-dire la dimension perpendiculaire à la face avant de la couche active 124) est ici comprise entre environ 50 µm et 1000 µm.

Dans l'exemple décrit ici, la portion 130.1 forme le premier élément électriquement conducteur 106. Les portions 130.2-130.4 sont chacune reliée à un contact métallique disposé sur une électrode de grille des transistors 104.1-104.3. Les portions 130.6, 130.8 et 130.10 sont chacune reliée à un contact métallique disposé sur une électrode de grille des transistors 110.1-110.3. Les portions 130.5, 130.7 et 130.9 forment chacune l'un des deuxièmes éléments électriquement conducteurs 108.1-108.3. La portion 130.11 forme le troisième élément électriquement conducteur 112.

Les portions électriquement conductrices 130 s'étendent dans un plan sensiblement parallèle à la couche active 124, facilitant la mise en contact de la structure 126 contre les pistes conductrices 118.

Plusieurs modules 119 peuvent être réalisés collectivement à l'échelle du wafer. Dans ce cas, les composants électroniques de puissance latéraux de plusieurs dispositifs électroniques de puissance sont réalisés à partir d'un même substrat, puis une couche métallique structurée destinée à former les structures d'interconnexion électrique 126 de ces modules est solidarisée aux électrodes des composants. L'assemblage obtenu est ensuite découpé dans les zones d'isolation des composants pour former les différents modules 119 qui sont ensuite reportés sur le support 114.

La couche métallique structurée est par exemple réalisée par usinage d'un disque métallique, ici de cuivre, de diamètre au moins égal à celui des wafers utilisés pour la réalisation des composants électroniques de puissance, et d'épaisseur par exemple égale à environ 300 µm, selon les motifs pour former les portions électriquement conductrices 130 et donc selon les connexions nécessaires entre les composants. Cet usinage forme par exemple des évidements de forme rectangulaire à travers la couche métallique, formant ainsi les portions conductrices 130 sous forme de parallélépipèdes rectangles.

La solidarisation de la couche métallique structurée aux pistes 118 est par exemple obtenue par un assemblage plaque à plaque via un collage métallique par thermocompression ou collage direct, par exemple un collage cuivre-cuivre.

La figure 6 représente un deuxième mode de réalisation du dispositif 100.

Contrairement au premier mode de réalisation précédemment décrit dans lequel la structure d'interconnexion électrique 126 est disposée contre la face avant 115 de la couche 116 du support 114, le module électronique 119 est ici reporté sur le support 114 tel que le substrat 120 soit disposé contre la face avant 115 de la couche 116, c'est-à-dire tel que la face active 124 soit disposée entre le support 114 et la structure d'interconnexion électrique 126.

Les portions électriquement conductrices 130 de la structure 126 comportent ici chacune une première partie 132 disposée contre la face avant de la couche active 124, c'est-à-dire contre la face avant des composants électroniques de puissance latéraux, et qui s'étend dans un plan sensiblement parallèle à la couche active 124, et une ou plusieurs deuxièmes parties 134 qui s'étendent à côté de la couche active 124 et qui relient électriquement la première partie 132 à l'une ou plusieurs des pistes électriquement conductrices 118 (non visibles sur la figure 6).

Contrairement aux premières parties 132 des portions 130 qui forment des parallélépipèdes rectangles orientés sensiblement parallèlement les uns aux autres et forment une structure plane sensiblement parallèle à la couche active 124, les deuxièmes parties 134 des portions 130 ne forment pas une structure conductrice plane. Ces deuxièmes parties 134 sont par exemple obtenues en pliant les parties des portions 130 qui ne sont pas disposées contre la couche active 124.

Dans ce deuxième mode de réalisation, l'évacuation de la chaleur générée par les composants électroniques de puissance latéraux au niveau de la face avant de la couche active 124 est réalisée du côté de la structure d'interconnexion électrique 126 et est découplée par rapport aux signaux électriques circulant dans les pistes conductrices 118 du fait que cette évacuation de la chaleur est réalisée du côté de la face du module 119 opposée à celle de trouvant contre le support 114 dans lequel les signaux électriques circulent.

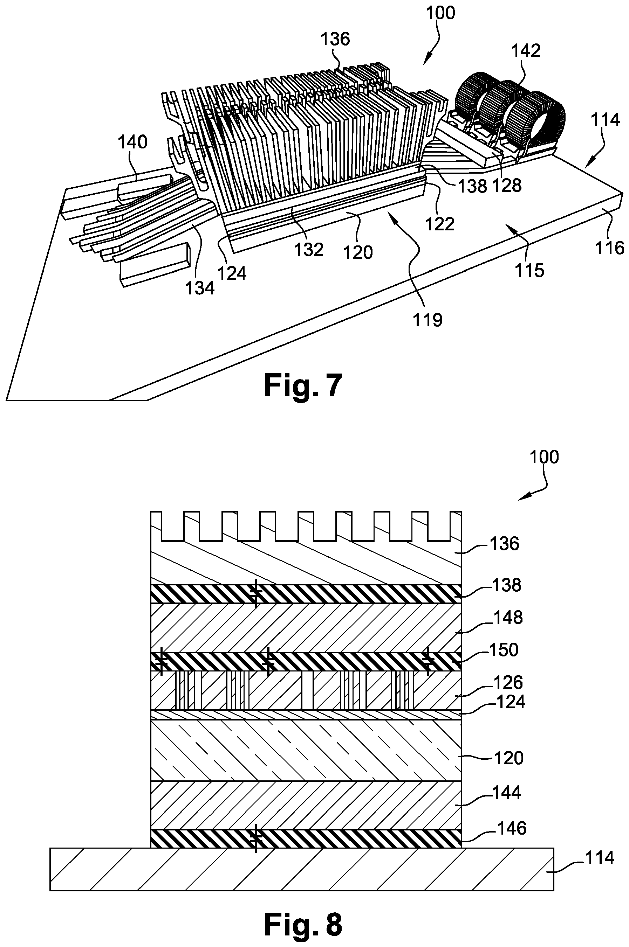

Comme représenté sur la figure 7, la structure plane formée par les premières parties 132 des portions 130 permet la solidarisation d'un dissipateur thermique 136 (de type dissipateur à ailettes sur la figure 7) sur la structure 126. Ainsi, l'évacuation de la chaleur est réalisée à travers la structure 126 et le dissipateur 136. Une couche diélectrique 138 est interposée entre le dissipateur 136 et la structure 126 pour éviter les court-circuits entre les différentes portions conductrices 130 de la structure 126 et d'isoler également le dissipateur 136 des potentiels électriques importants circulant dans la structure 126. Cette couche diélectrique 138 correspond par exemple à une couche céramique d'un substrat DBC ou toute autre couche diélectrique dont le matériau possède avantageusement une conductivité thermique importante (comme par exemple l'AIN, le kapton, etc.) pour réaliser au mieux le refroidissement des composants électroniques de puissance latéraux depuis leur face active.

Le dispositif 100 représenté sur la figure 7 comporte également d'autres éléments : un condensateur de découplage 128 disposé sur les deuxièmes parties 134 de portions 130, un circuit de commande 140 disposé sur le support 114 et des inductances de filtrage 142 des signaux de sortie du dispositif 100.

En variante, le condensateur 128 pourrait être disposé non pas sur les deuxièmes parties 134 des portions 130, mais à côté de celles-ci.

Pour la réalisation du dispositif 100 selon le deuxième mode de réalisation, les composants électroniques de puissance latéraux sont tout d'abord réalisés dans la couche active 124 qui est supportée mécaniquement par le substrat 120. Une découpe des couches 124, 122 et 120 est ensuite réalisée puis un ou plusieurs des empilements obtenus sont reportés sur la face avant 115 de la couche 116 du support 114. Les portions conductrices 130 sont ensuite solidarisées et reliées aux électrodes des composants, puis les liaisons électriques entres les pistes 118 et les deuxièmes parties 134 des portions 130 sont formées en pliant ces deuxièmes parties 134 des portions 130 et en les reliant électriquement aux pistes 118. La couche diélectrique 138 et le dissipateur 136 sont ensuite reportés sur les premières parties 132 des portions 130 de la structure 126. Le ou les condensateurs 128 sont ensuite solidarisés et reliés aux portions 130 au niveau des deuxièmes parties 134 des portions 130. Les autres éléments tels que le circuit de commande 140 et les inductances de filtrage 142 sont reportés sur le support 114.

En variante du premier mode de réalisation précédemment décrit, un dissipateur thermique par exemple similaire au dissipateur thermique 136 peut être disposé sous le support 114, avec une couche diélectrique interposée entre ce dissipateur thermique et le support 114.

Selon une variante du deuxième mode de réalisation, il est possible d'interposer entre le support 114 et le substrat 120, une première couche métallique 144 sur laquelle est appliqué l'un des potentiels électriques d'alimentation, par exemple le premier potentiel électrique d'alimentation (DC-, c'est-à-dire la masse dans l'exemple décrit ici), et une première couche diélectrique 146 formant une isolation électrique entre le support 114 et la première couche métallique 144. Une telle couche métallique 144 forme un premier écran électrostatique limitant les capacités parasites de mode commun pouvant être importantes en raison de la proximité des potentiels électriques de sortie du dispositif 100 délivrés dans la structure 126 avec le support 114.

De même, un deuxième écran électrostatique peut être réalisé en interposant une deuxième couche métallique 148 sur laquelle est appliqué l'un des potentiels électriques d'alimentation, par exemple le deuxième potentiel électrique d'alimentation (DC+), et une deuxième couche diélectrique 150 entre le la structure 126 et le dissipateur thermique 136.

La figure 8 est une vue en coupe du dispositif 100 comportant ces deux écrans électrostatiques. Ces écrans électrostatiques forment des equipotentiels remplissant un rôle de blindage évitant l'apparition de capacité parasite avec le dissipateur 136 et le support 114.

Lorsque le dispositif 100 selon le premier mode de réalisation comporte un dissipateur thermique disposé sur le substrat 120, les couches 148 et 150 peuvent être insérées entre ce dissipateur thermique et le substrat 120.

L'application d'un des potentiels électriques d'alimentation sur la première couche métallique 144 est obtenue en formant une liaison électrique entre la première couche métallique 144 et la portion conductrice 130 de la structure 126 dans laquelle circule ce potentiel électrique, par exemple via la création de cette liaison électrique en dehors du module 119 ou en réalisant un via conducteur qui traverse le substrat 120 et la couche active 124. De même, l'application de l'autre potentiel électrique d'alimentation sur la deuxième couche métallique 148 est obtenue en formant une liaison électrique entre la deuxième couche métallique 148 et la portion conductrice de la structure 126 dans laquelle circule cet autre potentiel électrique, par exemple en réalisant un via conducteur qui traverse la couche diélectrique 150.

Dans les deux modes de réalisation précédemment décrits, en présence ou non d'un ou de deux écrans électrostatiques, le substrat 120 est conservé dans le module 119.

En variante, il est possible que le substrat 120 soit supprimé. Dans le premier mode de réalisation, cette suppression du substrat 120 peut être réalisée avant ou après le report du module 119 sur le support 114, la structure d'interconnexion électrique 126 assurant le maintien mécanique des composants électroniques de puissance latéraux réalisés dans la couche active 124. Dans le deuxième mode de réalisation, la suppression du substrat 120 est réalisée avant le report du module 119 sur le support 114, et une couche diélectrique supplémentaire est alors interposée entre la couche active 124 et le support 114.

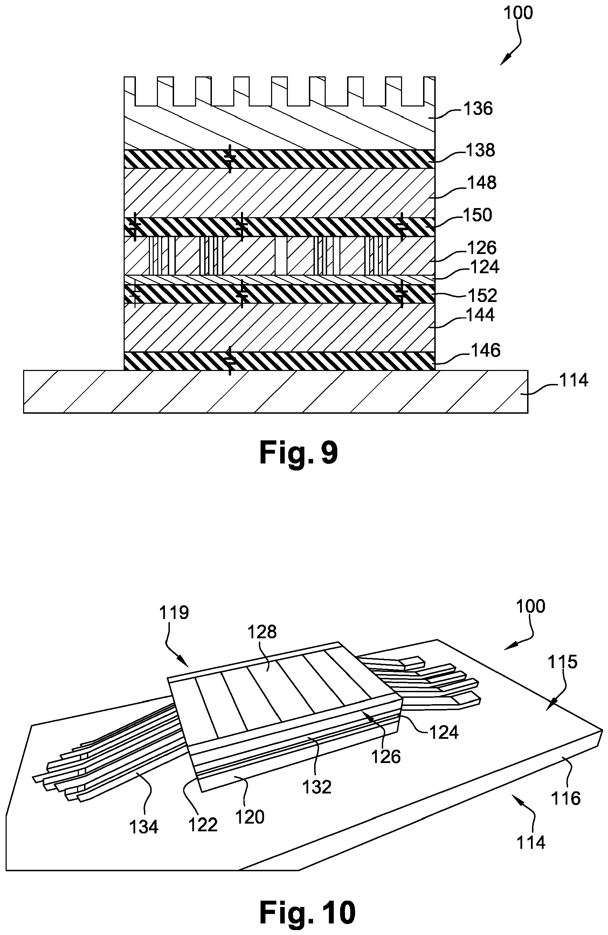

La figure 9 représente une vue en coupe du dispositif 100 selon le deuxième mode de réalisation comportant à la fois les deux écrans électrostatiques formés par les couches métalliques 144 et 148 et dans lequel le substrat semi-conducteur 120 ayant servi initialement à la réalisation des composants électroniques de puissance latéraux est supprimé. Dans cette configuration, la couche active 124 est isolée électriquement de la couche métallique 148 par la couche diélectrique supplémentaire 152.

La figure 10 représente une variante du deuxième mode de réalisation du dispositif 100.

Dans cette variante, les condensateurs de découplage 128 sont positionnés sur le convertisseur, sur les premières parties 132 des portions 130 de la structure 126. Ainsi, les condensateurs 128 sont positionnés au plus près du convertisseur, assurant ainsi un découplage optimal. Par contre, selon cette variante, les condensateurs 128 sont très proche de la zone actives des composants électroniques de puissance du dispositif 100 et sont donc soumis à la température de fonctionnement de ces composants.

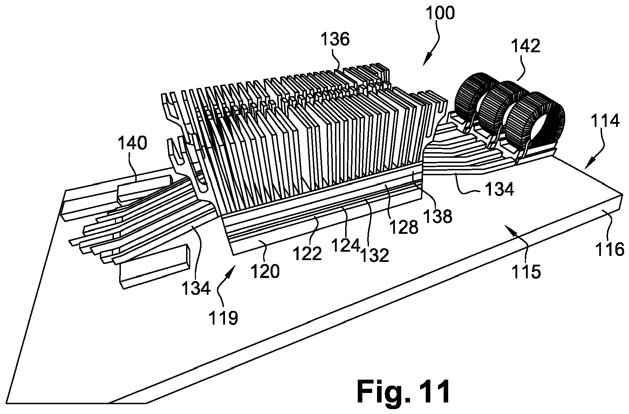

La figure 11 représente le dispositif 100 obtenu selon cette variante du deuxième mode de réalisation lorsque le dissipateur thermique 136 est positionné sur les condensateurs 128. Comme précédemment, la couche diélectrique 138 est interposée entre le dissipateur 136 et les condensateurs 128. Les condensateurs 128 forment donc ici une couche supplémentaire disposée entre le dissipateur thermique 136 et les portions 130 de la structure d'interconnexion électrique 126 augmentant la résistance thermique entre la zone active des composants électroniques de puissance et l'air ambiant. Le circuit de commande 140 et les inductances de filtrage 142 des signaux de sortie du dispositif 100 sont également disposés sur le support 114.

## Revendications

1. Dispositif électronique de puissance (100) comportant au moins :
- une couche active (124) comprenant au moins un semi-conducteur et dans laquelle plusieurs composants électroniques de puissance latéraux et/ou semi-latéraux (104, 110) sont réalisés, toutes les électrodes (123) des composants (104, 110) étant disposées sur une face avant (125) de la couche active (124) ;
- une structure d'interconnexion électrique (126) comprenant plusieurs portions électriquement conductrices (130) solidarisées à la face avant (125) de la couche active (124), auxquelles les électrodes (123) des composants (104, 110) sont reliées électriquement, et dont au moins des premières parties (132) disposées contre les électrodes (123) des composants (104, 110) s'étendent dans un plan sensiblement parallèle à la couche active (124) ;
- un support (114) comprenant une face avant (115) sur laquelle des pistes électriquement conductrices (118) sont disposées,
et dans lequel la couche active (124) et la structure d'interconnexion électrique (126) sont solidarisées à la face avant (115) du support (114) telles que :
- la structure d'interconnexion électrique (126) soit disposée entre la couche active (124) et le support (114), les premières parties (132) des portions électriquement conductrices (130) étant disposées contre les pistes électriquement conductrices (118), ou
- la couche active (124) soit disposée entre la structure d'interconnexion électrique (126) et le support (114), les portions électriquement conductrices (130) comportant en outre des deuxièmes parties (134) s'étendant à côté de la couche active (124) et reliant électriquement les premières parties (132) des portions électriquement conductrices (130) aux pistes électriquement conductrices (118).

2. Dispositif électronique de puissance (100) selon la revendication 1, dans lequel une épaisseur des portions électriquement conductrices (130) est comprise entre environ 50 µm et 1000 µm, et/ou dans lequel au moins les premières parties (132) des portions électriquement conductrices (130) forment des parallélépipèdes rectangles.

3. Dispositif électronique de puissance (100) selon l'une des revendications précédentes, dans lequel les électrodes (123) des composants (104, 110) sont planes.

4. Dispositif électronique de puissance (100) selon l'une des revendications précédentes, comportant en outre, lorsque la couche active (124) est disposée entre la structure d'interconnexion électrique (126) et le support (114), au moins un dissipateur thermique (136) disposé sur la structure d'interconnexion électrique (126) tel que la structure d'interconnexion électrique (126) soit disposée entre le dissipateur thermique (136) et la couche active (124).

5. Dispositif électronique de puissance (100) selon l'une des revendications précédentes, comportant en outre au moins un condensateur de découplage (128) tel que :
- lorsque la structure d'interconnexion électrique (126) est disposée entre la couche active (124) et le support (114), ledit au moins un condensateur de découplage (128) soit disposé sur une partie des pistes électriquement conductrices (118) et relié électriquement aux pistes électriquement conductrices (118), ou
- lorsque la couche active (124) est disposée entre la structure d'interconnexion électrique (126) et le support (114), ledit au moins un condensateur de découplage (128) soit disposé sur les deuxièmes parties (134) des portions électriquement conductrices (130) et relié électriquement aux deuxièmes parties (134) des portions électriquement conductrices (130), ou disposé sur les premières parties (132) des portions électriquement conductrices (130).

6. Dispositif électronique de puissance (100) selon les revendications 4 et 5, dans lequel, lorsque la couche active (124) est disposée entre la structure d'interconnexion électrique (126) et le support (114) et que ledit au moins un condensateur de découplage (128) est disposé sur les premières parties (132) des portions électriquement conductrices (130), le dissipateur thermique (136) est disposé sur ledit au moins un condensateurs de découplage (128).

7. Dispositif électronique de puissance (100) selon l'une des revendications précédentes, comportant en outre, lorsque la couche active (124) est disposée entre la structure d'interconnexion électrique (126) et le support (114), au moins une première couche métallique (144) disposée entre le support (114) et la couche active (124) et sur laquelle un premier potentiel d'alimentation électrique du dispositif électronique de puissance (100) est destiné à être appliqué et/ou, lorsque le dispositif électronique de puissance (100) comporte au moins un dissipateur thermique (136) disposé sur la structure d'interconnexion électrique (126), au moins une deuxième couche métallique (148) disposée entre le dissipateur thermique (136) et la structure d'interconnexion électrique (126) et sur laquelle un deuxième potentiel d'alimentation électrique du dispositif électronique de puissance (100) est destiné à être appliqué.

8. Dispositif électronique de puissance (100) selon l'une des revendications précédentes, dans lequel :
- la couche active (124) comporte au moins du GaN et/ou de l'AIGaN et/ou de l'AIN, et/ou les composants (104, 110) comportent des transistors de type HEMT, ou
- la couche active (124) comporte au moins du silicium, et/ou les composants (104, 110) comportent des transistors de type MOS et/ou JFET et/ou IGBT et/ou BJT et/ou DMOS.

9. Dispositif électronique de puissance (100) selon l'une des revendications précédentes, dans lequel au moins une partie des composants (104, 110) forment au moins une cellule de commutation (102), et/ou dans lequel le dispositif électronique de puissance (100) comporte au moins un convertisseur statique comprenant plusieurs cellules de commutation (102) reliées électriquement entre elles.

10. Dispositif électronique de puissance (100) selon l'une des revendications précédentes, dans lequel les composants (104, 110) sont disposés sur au moins un substrat semi-conducteur (120) tel que :
- lorsque la structure d'interconnexion électrique (126) est disposée entre la couche active (124) et le support (114), la couche active (124) est disposée entre le substrat semi-conducteur (120) et la structure d'interconnexion électrique (126), ou
- lorsque la couche active (124) est disposée entre la structure d'interconnexion électrique (126) et le support (114), le substrat semi-conducteur (120) est disposé entre la couche active (124) et le support (114).

11. Procédé de réalisation d'un dispositif électronique de puissance (100), comportant au moins la mise en œuvre des étapes suivantes :
- réalisation de plusieurs composants électroniques de puissance latéraux et/ou semi-latéraux (104, 110) dans au moins une couche active (124) comprenant au moins un semi-conducteur tels que toutes les électrodes (123) des composants (104, 110) soient disposées sur une face avant (125) de la couche active (124) ;
- solidarisation de la face avant (125) de la couche active (124) à une structure d'interconnexion électrique (126) comprenant plusieurs portions électriquement conductrices (130) auxquelles les électrodes (123) des composants (104, 110) sont reliées électriquement, et dont au moins des premières parties (132) disposées contre les électrodes (123) des composants (104, 110) s'étendent dans un plan sensiblement parallèle à la couche active (124) ;
- solidarisation de la couche active (124) et de la structure d'interconnexion électrique (126) à une face avant (115) d'un support (114) sur laquelle s'étendent des pistes électriquement conductrices (118), telle que :
• la structure d'interconnexion électrique (126) soit disposée entre la couche active (124) et le support (114), les premières parties (132) des portions électriquement conductrices (130) étant disposées contre les pistes électriquement conductrices (118), ou
• la couche active (124) soit disposée entre la structure d'interconnexion électrique (126) et le support (114), les portions électriquement conductrices (130) comportant des deuxièmes parties (134) s'étendant à côté de la couche active (124) et reliant électriquement les premières parties (132) des portions électriquement conductrices (130) aux pistes électriquement conductrices (118).

12. Procédé selon la revendication 11, dans lequel, lorsque la structure d'interconnexion électrique (126) est disposée entre la couche active (124) et le support (114) :
- les composants (104, 110) sont réalisés collectivement dans la couche active (124) qui est disposée sur un substrat semi-conducteur (120),
- la solidarisation de la face avant (125) de la couche active (124) à la structure d'interconnexion électrique (126) correspond à une solidarisation de la face avant (125) de la couche active (124) à une couche métallique structurée destinée à former la structure d'interconnexion électrique (126).

13. Procédé selon la revendication 12, comportant en outre, entre la solidarisation de la face avant (125) de la couche active (124) à la couche métallique structurée et la solidarisation de la couche active (124) et de la structure d'interconnexion électrique (126) à la face avant (115) du support (114), une étape de suppression du substrat semi-conducteur (120).

14. Procédé selon l'une des revendications 12 ou 13, le procédé comportant en outre, entre la solidarisation de la face avant (125) de la couche active (124) à la couche métallique structurée et la solidarisation de la couche active (124) et de la structure d'interconnexion électrique (126) à la face avant (115) du support (114), une étape de découpe d'au moins la couche active (124) et la couche métallique structurée, formant un empilement qui est ensuite reporté sur la face avant (115) du support (114).

15. Procédé selon la revendication 11 dans lequel, lorsque la couche active (124) est disposée entre la structure d'interconnexion électrique (126) et le support (114) :
- les composants (104, 110) sont réalisés collectivement dans la couche active (124) qui est disposée sur un substrat semi-conducteur (120),
- la couche active (124) est solidarisée à la face avant (115) du support (114) avant la solidarisation de la structure d'interconnexion électrique (126) à la face avant (125) de la couche active (124),
et le procédé comporte en outre, entre la réalisation des composants (104, 110) et la solidarisation de la couche active (124) à la face avant (115) du support (114), une étape de découpe du substrat semi-conducteur (120) et de la couche active (124), formant un empilement qui est ensuite reporté sur la face avant (115) du support (114).

## Patentansprüche

1. Elektronische Leistungsvorrichtung (100), wenigstens umfassend:
- eine aktive Schicht (124), welche wenigstens einen Halbleiter umfasst und in welcher mehrere laterale und oder halblaterale elektronische Leistungskomponenten (104, 110) gebildet sind, wobei alle Elektroden (123) der Komponenten (104, 110) an einer vorderen Fläche (125) der aktiven Schicht (124) angeordnet sind;
- eine elektrische Verbindungsstruktur (126), welche mehrere elektrisch leitfähige Abschnitte (130) umfasst, welche an der vorderen Fläche (125) der aktiven Schicht (124) angebracht sind, an welchen die Elektroden (123) der Komponenten (104, 110) elektrisch angeschlossen sind, und von welcher sich wenigstens erste Teile (132), welche gegen die Elektroden (123) der Komponenten (104, 110) angeordnet sind, in einer Ebene erstrecken, welche im Wesentlichen parallel zu der aktiven Schicht (124) ist;
- einen Träger (114), welcher eine vordere Fläche (115) umfasst, an welcher elektrisch leitfähige Bahnen (118) angeordnet sind,
und wobei die aktive Schicht (124) und die elektrische Verbindungsstruktur (126) an der vorderen Fläche (115) des Trägers (114) derart angebracht sind, dass:
- die elektrische Verbindungsstruktur (126) zwischen der aktiven Schicht (124) und dem Träger (114) angeordnet ist, wobei die ersten Teile (132) der elektrisch leitfähigen Abschnitte (130) gegen die elektrisch leitfähigen Bahnen (118) angeordnet sind, oder
- die aktive Schicht (124) zwischen der elektrischen Verbindungsstruktur (126) und dem Träger (114) angeordnet ist, wobei die elektrisch leitfähigen Abschnitte (130) ferner zweite Teile (134) umfassen, welche sich seitlich der aktiven Schicht (124) erstrecken und die ersten Teile (132) der elektrisch leitfähigen Abschnitte (130) mit den elektrisch leitfähigen Bahnen (118) elektrisch koppeln.

2. Elektronische Leistungsvorrichtung (100) nach Anspruch 1, wobei eine Dicke der elektrisch leitfähigen Abschnitte (130) zwischen etwa 50 µm und 1000 µm beträgt, und/oder wobei wenigstens die ersten Teile (132) der elektrisch leitfähigen Abschnitte (130) rechteckige Parallelepipede bilden.

3. Elektrische Leistungsvorrichtung (100) nach einem der vorhergehenden Ansprüche, wobei die Elektroden (123) der Komponenten (104, 110) eben sind.

4. Elektronische Leistungsvorrichtung (100) nach einem der vorhergehenden Ansprüche, ferner umfassend, wenn die aktive Schicht (124) zwischen der elektrischen Verbindungsstruktur (126) und dem Träger (114) angeordnet ist, wenigstens eine thermische Ableitung (136), welche an der elektrischen Verbindungsstruktur (126) derart angeordnet ist, dass die elektrische Verbindungsstruktur (126) zwischen der thermischen Ableitung (136) und der aktiven Schicht (124) angeordnet ist.

5. Elektrische Leistungsvorrichtung (100) nach einem der vorhergehenden Ansprüche, ferner umfassend wenigstens einen Entkopplungskondensator (128) derart, dass:
- wenn die elektrische Verbindungsstruktur (126) zwischen der aktiven Schicht (124) und dem Träger (114) angeordnet ist, der wenigstens eine Entkopplungskondensator (128) an einem Teil der elektrisch leitfähigen Bahnen (118) angeordnet und mit den elektrisch leitfähigen Bahnen (118) elektrisch gekoppelt ist, oder
- wenn die aktive Schicht (124) zwischen der elektrischen Verbindungsstruktur (126) und dem Träger (114) angeordnet ist, der wenigstens eine Entkopplungskondensator (128) an den zweiten Teilen (134) der elektrisch leitfähigen Abschnitte (130) angeordnet ist und mit den zweiten Teilen (134) der elektrisch leitfähigen Abschnitte (130) elektrisch gekoppelt ist oder an den ersten Teilen (132) der elektrisch leitfähigen Abschnitte (130) angeordnet ist.

6. Elektrische Leistungsvorrichtung (100) nach den Ansprüche 4 und 5, wobei wenn die aktive Schicht (124) zwischen der elektrischen Verbindungsstruktur (126) und dem Träger (114) angeordnet ist, und wenn der wenigstens eine Entkopplungskondensator (128) an den ersten Teilen (132) der elektrisch leitfähigen Abschnitte (130) angeordnet ist, die thermische Ableitung (136) an dem wenigstens einen Entkopplungskondensator (128) angeordnet ist.

7. Elektrische Leistungsvorrichtung (100) nach einem der vorhergehenden Ansprüche, ferner umfassend, wenn die aktive Schicht (124) zwischen der elektrischen Verbindungsstruktur (126) und dem Träger (114) angeordnet ist, wenigstens eine erste metallische Schicht (144), welche zwischen dem Träger (114) und der aktiven Schicht (124) angeordnet ist und an welche ein erstes elektrisches Versorgungspotential der elektronischen Leistungsvorrichtung (100) anzulegen vorgesehen ist und/oder wenn die elektronische Leistungsvorrichtung (100) wenigstens eine thermische Ableitung (136) umfasst, welche an der elektrischen Verbindungsstruktur (126) angeordnet ist, wenigstens eine zweite metallische Schicht (148), welche zwischen der thermischen Ableitung (136) und der elektrischen Verbindungsstruktur (126) angeordnet ist und an welcher ein zweites elektrisches Versorgungspotential der elektronischen Leistungsvorrichtung (100) anzulegen vorgesehen ist.

8. Elektronische Leistungsvorrichtung (100) nach einem der vorhergehenden Ansprüche, wobei:
- die aktive Schicht (124) wenigstens GaN und/oder AIGaN und/oder AIN umfasst und/oder die Komponenten (104, 110) Transistoren vom HEMT-Typ umfassen, oder
- die aktive Schicht (124) wenigstens Silizium umfasst und/oder die Komponenten (104, 110) Transistoren vom MOS und/oder JFET und/oder IGBT und/oder BJT und/oder DMOS-Typ umfassen.

9. Elektronische Leistungsvorrichtung (100) nach einem der vorhergehenden Ansprüche, wobei wenigstens ein Teil der Komponenten (104, 110) wenigstens eine Kommutationszelle (102) bildet und/oder wobei die elektronische Leistungsvorrichtung (100) wenigstens einen statischen Umrichter umfasst, welcher mehrere Kommutationszellen (102) umfasst, welche untereinander elektrisch gekoppelt sind.

10. Elektronische Leistungsvorrichtung (100) nach einem der vorhergehenden Ansprüche, wobei die Komponenten (104, 110) an wenigstens einem Halbleiter-Substrat (120) derart angeordnet sind, dass:
- wenn die elektrische Verbindungsstruktur (126) zwischen der aktiven Schicht (124) und dem Träger (114) angeordnet ist, die aktive Schicht (124) zwischen dem Halbleiter-Substrat (120) und der elektrischen Verbindungsstruktur (126) angeordnet ist, oder
- wenn die aktive Schicht (124) zwischen der elektrischen Verbindungsstruktur (126) und dem Träger (114) angeordnet ist, das Halbleiter-Substrat (120) zwischen der aktiven Schicht (124) und dem Träger (114) angeordnet ist.

11. Verfahren zum Herstellen einer elektronischen Leistungsvorrichtung (100), umfassend das Ausführen der folgenden Schritte:
- Bilden von mehreren lateralen oder halblateralen elektronischen Leistungskomponenten (104, 110) in wenigstens einer aktiven Schicht (124), umfassend wenigstens einen Halbleiter derart, dass alle der Elektroden (123) der Komponenten (104, 110) an einer vorderen Fläche (125) der aktiven Schicht (124) angeordnet sind;
- Anbringen der vorderen Fläche (125) der aktiven Schicht (124) an einer elektrischen Verbindungsstruktur (126), umfassend mehrere elektrisch leitfähige Abschnitte (130), an welche die Elektroden (123) der Komponenten (104, 110) elektrisch gekoppelt sind, und von welchen sich wenigstens erste Teile (132), welche gegen die Elektroden (123) der Komponenten (104, 110) angeordnet sind, in einer Ebene erstrecken, welche im Wesentlichen parallel zu der aktiven Schicht (124) ist;
- Anbringen der aktiven Schicht (124) und der elektrischen Verbindungsstruktur (126) an einer vorderen Fläche (115) eines Trägers (114), an welcher sich elektrisch leitfähige Bahnen (118) erstrecken, derart, dass:
∘ die elektrische Verbindungsstruktur (126) zwischen der aktiven Schicht (124) und dem Träger (114) angeordnet wird, wobei die ersten Teile (132) der elektrisch leitfähigen Abschnitte (130) gegen die elektrisch leitfähigen Bahnen (118) angeordnet werden, oder
∘ die aktive Schicht (124) zwischen der elektrischen Verbindungsstruktur (126) und dem Träger (114) angeordnet wird, wobei die elektrisch leitfähigen Abschnitte (130) zweite Teile (134) umfassen, welche sich seitlich der aktiven Schicht (124) erstrecken und die ersten Teile (132) der elektrisch leitfähigen Abschnitte (130) mit den elektrisch leitfähigen Bahnen (118) elektrisch koppeln.

12. Verfahren nach Anspruch 11, wobei wenn die elektrische Verbindungsstruktur (126) zwischen der aktiven Schicht (124) und dem Träger (114) angeordnet ist:
- die Komponenten (104, 110) kollektiv in der aktiven Schicht (124) gebildet werden, welche an einem Halbleiter-Substrat (120) angeordnet wird,
- die Anbringung der vorderen Fläche (125) der aktiven Schicht (124) an der elektrischen Verbindungsstruktur (126) einem Anbringen der vorderen Fläche (125) der aktiven Schicht (124) an einer strukturierten metallischen Schicht entspricht, welche dazu vorgesehen ist, die elektrische Verbindungsstruktur (126) zu bilden.

13. Verfahren nach Anspruch 12, ferner umfassend zwischen dem Anbringen der vorderen Fläche (125) der aktiven Schicht (124) an der strukturierten metallischen Schicht und dem Anbringen der aktiven Schicht (124) und der elektrischen Verbindungsstruktur (126) an der vorderen Fläche (115) des Trägers (114) einen Schritt eines Beseitigens des Halbleiter-Substrats (120).

14. Verfahren nach einem der Ansprüche 12 oder 13, wobei das Verfahren ferner zwischen dem Anbringen der vorderen Fläche (125) der aktiven Schicht (124) an der strukturierten metallischen Schicht und dem Anbringen der aktiven Schicht (124) und der elektrischen Verbindungsstruktur (126) an der vorderen Fläche (115) des Trägers (114) einen Schritt eines Schneidens von wenigstens der aktiven Schicht (124) und der strukturierten metallischen Schicht umfasst, wobei ein Stapel gebildet wird, welcher anschließend auf die vordere Fläche (115) des Trägers (114) übertragen wird.

15. Verfahren nach Anspruch 11, wobei wenn die aktive Schicht (124) zwischen der elektrischen Verbindungsstruktur (126) und dem Träger (114) angeordnet ist:
- die Komponenten (104, 110) kollektiv in der aktiven Schicht (124) gebildet werden, welche an einem Halbleiter-Substrat (120) angeordnet wird,
- die aktive Schicht (124) an der vorderen Fläche (115) des Trägers (114) vor dem Anbringen der elektrischen Verbindungsstruktur (126) an der vorderen Fläche (125) der aktiven Schicht (124) angebracht wird,
und das Verfahren ferner zwischen dem Bilden der Komponenten (104, 110) und dem Anbringen der aktiven Schicht (124) an der vorderen Schicht (115) des Trägers (114) einen Schritt eines Schneidens des Halbleiter-Substrats (120) und der aktiven Schicht (124) umfasst, wobei ein Stapel gebildet wird, welcher anschließend auf die vordere Fläche (115) des Trägers (114) übertragen wird.

## Claims

1. Electronic power device (100) comprising at least:
- an active layer (124) comprising at least one semiconductor and in which several lateral and/or semi-lateral electronic power components (104, 110) are made, all electrodes (123) of the components (104, 110) being located on a front face (125) of the active layer (124);
- an electrical interconnection structure (126) comprising several electrically conducting portions (130) secured to the front face (125) of the active layer (124), to which the electrodes (123) of the components (104, 110) are electrically connected, and of which at least first parts (132) placed in contact with the electrodes (123) of the components (104, 110) extend in a plane approximately parallel to the active layer (124);
- a support (114) comprising a front face (115) on which electrically conducting tracks (118) are located,
and in which the active layer (124) and the electrical interconnection structure (126) are secured to the front face (115) of the support (114) such that:
- the electrical interconnection structure (126) is located between the active layer (124) and the support (114), the first parts (132) of the electrically conducting portions (130) being placed in contact with the electrically conducting tracks (118), or
- the active layer (124) is located between the electrical interconnection structure (126) and the support (114), the electrically conducting portions (130) also comprising second parts (134) extending next to the active layer (124) and electrically connecting the first parts (132) of the electrically conducting portions (130) to the electrically conducting tracks (118).

2. Electronic power device (100) according to claim 1, in which a thickness of the electrically conducting portions (130) is between about 50 µm and 1000 µm, and/or in which at least the first parts (132) of the electrically conducting portions (130) form rectangular parallelepipeds.

3. Electronic power device (100) according to one of preceding claims, wherein the electrodes (123) of the components (104, 110) are flat.

4. Electronic power device (100) according to one of previous claims, also comprising, when the active layer (124) is located between the electrical interconnection structure (126) and the support (114), at least one heat sink (136) located on the electrical interconnection structure (126) such that the electrical interconnection structure (126) is located between the heat sink (136) and the active layer (124).

5. Electronic power device (100) according to one of previous claims, also comprising at least one decoupling capacitor (128) such that:
- when the electrical interconnection structure (126) is located between the active layer (124) and the support (114), said at least one decoupling capacitor (128) is placed on a part of the electrically conducting tracks (118) and is electrically connected to the electrically conducting tracks (118), or
- when the active layer (124) is located between the electrical interconnection structure (126) and the support (114), said at least one decoupling capacitor (128) is placed on the second parts (134) of the electrically conducting portions (130) and is electrically connected to the second parts (134) of the electrically conducting portions (130), or is placed on the first parts (132) of the electrically conducting portions (130).

6. Electronic power device (100) according to claims 4 and 5, wherein, when the active layer (124) is located between the electrical interconnection structure (126) and the support (114) and said at least one decoupling capacitor (128) is placed on the first parts (132) of the electrically conducting portions (130), the heat sink (136) is located on said at least one decoupling capacitor (128).

7. Electronic power device (100) according to one of previous claims, also comprising, when the active layer (124) is located between the electric interconnection structure (126) and the support (114), at least one first metallic layer (144) located between the support (114) and the active layer (124) and onto which a first electrical power supply potential of the electronic power device (100) is intended to be applied and/or, when the electronic power device (100) comprises at least one heat sink (136) arranged on the electrical interconnection structure (126), at least one second metallic layer (148) located between the heat sink (136) and the electrical interconnection structure (126) and onto which a second electrical power supply potential of the electronic power device (100) is intended to be applied.

8. Electronic power device (100) according to one of previous claims, in which:
- the active layer (124) comprises at least GaN and/or AIGaN and/or AIN, and/or the components (104, 110) comprise HEMT type transistors, or
- the active layer (124) comprises at least silicon, and/or the components (104, 110) comprise MOS and/or JFET and/or IGBT and/or BJT and/or DMOS type transistors.

9. Electronic power device (100) according to one of previous claims, in which at least some of the components (104, 110) form at least one switching cell (102), and/or in which the electronic power device (100) comprises at least one static converter comprising several switching cells (102) electrically connected to each other.

10. Electronic power device (100) according to one of previous claims, in which the components (104, 110) are located on at least one semiconducting substrate such that:
- when the electrical interconnection structure (126) is located between the active layer (124) and the support (114), the active layer (124) is located between the semiconducting substrate (120) and the electrical interconnection structure (126), or
- when the active layer (124) is located between the electrical interconnection structure (126) and the support (114), the semiconducting substrate (120) is located between the active layer (124) and the support (114).

11. Method of making an electronic power device (100) comprising at least implementation of the following steps:
- make several lateral and/or semi-lateral electronic power components (104, 110) in at least one active layer (124) comprising at least one semiconductor such that all electrodes (123) of the components (104, 110) are located on a front face (125) of the active layer (124);
- attachment of the front face (125) of the active layer (124) to an electrical interconnection structure (126) comprising several electrically conducting portions (130) to which the electrodes (123) of the components (104, 110) are electrically connected, and of which at least first parts (132) located in contact with the electrodes (123) of the components (104, 110) extend in a plane approximately parallel to the active layer (124);
- attachment of the active layer (124) and the electrical interconnection structure (126) to a front face (125) of a support (114) on which electrically conducting tracks (118) extend, such that:
• the electrical interconnection structure (126) is located between the active layer (124) and the support (114), the first parts (132) of the electrically conducting portions (130) being placed in contact with the electrically conducting tracks (118), or
• the active layer (124) is located between the electrical interconnection structure (126) and the support (114), the electrically conducting portions (130) comprising second parts (134) extending next to the active layer (124) and electrically connecting the first parts (132) of the electrically conducting portions (130) to the electrically conducting tracks (118).

12. Method according to claim 11, in which when the electrical interconnection structure (126) is located between the active layer (124) and the support (114) :
- the components (104, 110) are made collectively in the active layer (124) that is located on a semiconducting substrate (120),
- the attachment of the front face (125) of the active layer (124) to the electrical interconnection structure (126) corresponds to an attachment of the front face (125) of the active layer (124) to a structured metallic layer that is intended to form the electrical interconnection structure (126).

13. Method according to claim 12, also including a step to eliminate the semiconducting substrate (120), between the attachment of the front face (125) of the active layer (124) to the structured metallic layer and the attachment of the active layer (124) and the electrical interconnection structure (126) to the front face (115) of the support (114).

14. Method according to one of claims 12 or 13, also including a step to cut out at least the active layer (124) and the structured metallic layer, between the attachment of the front face (125) of the active layer (124) to the structured metallic layer and the attachment of the active layer (124) and the electrical interconnection structure (126) to the front face (115) of the support (114), forming a stack that is then transferred onto the front face (115) of the support (114).

15. Method according to claim 11, in which, when the active layer (124) is located between the electrical interconnection structure (126) and the support (114):
- the components (104, 110) are made collectively in the active layer (124) that is located on a semiconducting substrate (120),
- the active layer (124) is secured to the front face (115) of the support (114) before the attachment of the electrical interconnection structure (126) to the front face (125) of the active layer (124),
and the method also includes a step to cut out the semiconducting substrate (120) and the active layer (124), between the making of the components (104, 110) and the attachment of the active layer (124) to the front face (115) of the support (114), forming a stack that is then transferred onto the front face (115) of the support (114).
